# EUROPEAN PATENT SPECIFICATION

(11) **EP 2 380 411 B1**
(45) Date of publication and mention of the grant of the patent: **15.04.2015**
(21) Application number: 09775314.9
(22) Date of filing: 09.12.2009
(51) Int. Cl.: H05G 2/00

(54) **METHOD AND DEVICE FOR GENERATING EUV RADIATION OR SOFT X-RAYS WITH ENHANCED EFFICIENCY**
VERFAHREN UND EINRICHTUNG ZUM ERZEUGEN VON EUV-STRAHLUNG ODER WEICHEN RÖNTGENSTRAHLEN MIT ERHÖHTEM WIRKUNGSGRAD
PROCÉDÉ ET DISPOSITIF POUR PRODUIRE UN RAYONNEMENT EUV OU DES RAYONS X MOUS AVEC UN RENDEMENT OPTIMISÉ

(30) Priority: 16.12.2008 EP 08171838
(43) Date of publication of application: 26.10.2011
(73) Proprietor: Philips Deutschland GmbH, 20099 Hamburg (DE); Koninklijke Philips N.V., 5656 AE Eindhoven (NL); Fraunhofer Gesellschaft zur Förderung der angewandten Forschung e.V., 80686 München (DE); Ushio Denki Kabushiki Kaisha, Tokyo-to (JP)
(72) Inventor: JONKERS, Jeroen, NL-5656 AE Eindhoven (NL); KUEPPER, Felix, A., NL-5656 AE Eindhoven (NL); VERBRAAK, Harald, E., NL-5656 AE Eindhoven (NL); NEFF, Jakob, W., NL-5656 AE Eindhoven (NL)
(74) Representative: van Eeuwijk, Alexander Henricus Waltherus
(86) International application number: PCT/IB2009/055598
(87) International publication number: WO 2010/070540

(56) References cited:
- EP-A1- 2 046 100
- EP-A1- 2 170 020
- EP-A2- 1 976 344
- WO-A1-2010/013167

## Description

### FIELD OF THE INVENTION

The present invention relates to a method and device for generating optical radiation, in particular EUV radiation or soft x-rays, by means of electrically operated discharges, wherein a plasma is ignited in a gaseous medium between at least two electrodes in a discharge space, said plasma emitting said radiation that is to be generated, and wherein said gaseous medium is produced at least partly from a liquid material which is applied to a one or several surface(s) moving in said discharge space and is at least partially evaporated by one or several pulsed energy beams. Such discharge based light sources when emitting EUV radiation or soft x-rays, in particular in the wavelength range between approximately 1 and 20 nm, are mainly required in the field of EUV lithography and metrology.

### BACKGROUND OF THE INVENTION

In light sources of the above kind the radiation is emitted from hot plasma produced by a pulsed current. Very powerful EUV radiation generating devices are operated with metal vapor to generate the required plasma. An example of such a device is shown in WO2005/025280 A2. In this known EUV radiation generating device the metal vapor is produced from a metal melt which is applied to a surface in the discharge space and at least partially evaporated by a pulsed energy beam, in particular a laser beam. In a preferred embodiment of this device the two electrodes are rotatably mounted forming electrode wheels which are rotated during operation of the device. The electrode wheels dip during rotation into containers with the metal melt. A pulsed laser beam is directed directly to the surface of one of the electrodes in order to generate the metal vapor from the applied metal melt. This metal vapor cloud expands towards the second electrode and leads to a short circuit between the two electrodes which are connected to a charged capacitor bank, thus igniting the electrical discharge. Due to the low inductance of the electrical circuit, an electrical pulse with a few tens of kA is created that heats the plasma to several tens of eV within around 100 ns. Through this heating the desired ionization stages are exited and radiation in the EUV region is emitted from a pinch plasma. The conversion efficiency is defined as the ratio of EUV radiation, i.e. a 2 % bandwidth centered on 13.5 nm, emitted in 2π sr and the energy initially stored at the capacitor bank.

For application of this EUV radiation in a EUV scanner not only the amount of EUV radiation produced per pulse is of interest, but also the fraction that can be used by the scanner. This holds only for the radiation originating from a sphere with around 1 mm diameter. The exact diameter depends on the solid angle of the collector optics and the étendue of the scanner. Especially for discharge produced plasmas, like the above of the so called "Aachener Lampe", it is known that not all of the produced EUV radiation is centered within the above collectable volume. This is mainly due to the large region between the center of the plasma and one of the electrodes from which region EUV is emitted as well. In spite of the low intensity, the total amount of energy emitted from this region is still significant due to its large volume. The collectable conversion efficiency (CCE) is the ratio of collectable EUV radiation and the electrical pulse energy, and is therefore the metric for the overall efficiency of the EUV generation.

### SUMMARY OF THE INVENTION

It is an object of the present invention to provide a method and device for generating optical radiation, in particular EUV radiation or soft x-rays, by means of an electrically operated discharge with enhanced collectable conversion efficiency.

The object is achieved with the device and method according to claims 1 and 7. Advantageous embodiments of the method and device are subject of the dependent claims and are furthermore described in the following portions of the description.

In the proposed method a plasma is ignited in a gaseous medium between at least two electrodes in a discharge space, said plasma emitting the radiation that is to be generated. The gaseous medium is produced at least partly from a liquid material, in particular a metal melt, which is applied to one or several surface(s) moving in the discharge space and is at least partially evaporated by one or several pulsed energy beams, which may be, for example, ion or electron beams and in a preferred embodiment are laser beams. The pulses of the pulsed energy beam(s) are generated such that within a time interval of each electrical discharge at least two consecutive pulses of the pulsed energy beam(s) are directed onto the surface(s) evaporating the applied liquid material.

The corresponding device comprises at least two electrodes arranged in a discharge space at a distance from one another which allows ignition of a plasma in a gaseous medium between the electrodes, a device for applying a liquid material to one or several surface(s) moving in said discharge space and an energy beam device adapted to direct one or several pulsed energy beams onto said surface(s) evaporating said applied liquid material at least partially and thereby producing at least part of said gaseous medium. The energy beam device is designed to apply within a time interval of each electrical discharge at least two consecutive pulses of the pulsed energy beam(s) onto said surface(s). The proposed device may otherwise be constructed like the device described in WO2005/025280 A2.

A main aspect of the proposed method and device is to apply not only one single energy beam pulse for each electrode discharge, but to apply at least two consecutive pulses within the time interval of each electrical discharge or current pulse. The time interval starts with the application of the first energy beam pulse initiating the corresponding electrical discharge and ends when the capacitor bank is discharged after the corresponding current pulse. Due to the evaporation of liquid material by two or more consecutive pulses during each electrical discharge the spatial distribution of the plasma and thus of the generated radiation is much more concentrated in the volume than is the case when using only one single energy beam pulse per discharge. This results in an increase of collectable conversion efficiency such that much more of the generated radiation can be used by a scanner. Another advantage of the more concentrated radiation emission is that the high intensity region is situated closer to the middle of the collection volume than is the case with one single pulse, which also improves the optical performance of a scanner in which the radiation is used.

In an advantageous embodiment of the method and device the at least two consecutive pulses are applied with a mutual time delay of ≤ 300 ns. With such a short time distance a significant increase in the collectable conversion efficiencies is achieved compared to the use of only one single pulse. The at least two consecutive pulses can be generated by using two separate energy beam sources, in particular laser sources, each having their own trigger in order to achieve the appropriate timing.

Dependent on the application several parameters may be optimized in order to get maximum collectable conversion efficiency for the corresponding application. These parameters are the time delay between the consecutive pulses, the control of which is mandatory in all cases according to the claims, the polarization of the consecutive pulses, the wavelengths of the consecutive pulses, the spatial and temporal intensity distribution of the consecutive pulses on the moving surface(s) as well as the angle of incidence of these pulses on the moving surface(s). This also means, that each of the two or more consecutive pulses may have another polarization, wavelength, spatial and temporal intensity distribution on the moving surface(s) and angle of incidence on the moving surface(s). The spatial intensity distribution may be controlled by a separate optics for each individual laser beam. The optimization may be performed with one or all or any possible combination of the above parameters.

According to the invention, at least the time delay out of the above parameters is controlled based on appropriate measurements with a diagnostics unit. These measurements include the EUV yield in the collectable volume and/or include a measurement of the amount of fast ions emitted by the plasma. When measuring the EUV yield with appropriate radiation detectors, like for example back lighted CCD cameras or photodiodes, the parameters are advantageously optimized to get the maximum EUV yield in the collectable volume. When measuring the output of fast ions, the parameters may be controlled to achieve the lowest output of fast ions that may sputter the collector. The corresponding device in the above cases comprises a control unit which controls at least one of the above parameters based on the measurement results.

For measuring the output of fast ions, a small pick-up coil can be located in the vicinity of the capacitor bank or of the electrode system. This coil produces a voltage that is proportional to the time-derivative of the current as both are proportional to the magnetic field. That is why this pick-up coil is also called dI/dt probe. From the dependency of the dI/dt signal on time, the pinch dynamics can be derived which on its hand gives information whether the production of fast ions is successfully suppressed or not. Fast ions with kinetic energies above 10 keV are harmful as they can be hardly stopped by the debris mitigation system, so that they sputter away the optical coating of the collector mirror. In order to achieve a collector life-time of at least a year, successfully reducing the production of fast ions is necessary. This may be obtained with the above described control unit.

The at least two consecutive pulses may be applied to the same lateral location of the moving surface(s) with respect to the moving direction of this surface(s), in particular the moving electrode surface(s). In an advantageous embodiment, the consecutive pulses are applied at different lateral locations with respect to this moving direction. This allows a better usage of the liquid material applied to the surface(s) and may also be used to achieve a better spatial distribution of the generated plasma. In this context the term lateral means a direction on the surface perpendicular to the moving direction of the surface. With this technique the discharge volume can be expanded in directions in which this volume normally has a small extension. Since the spatial fluctuations of the discharge cloud or volume do not change compared to the application of only a single pulse, the relative fluctuations of the discharge volume are smaller with such a technique. Furthermore, by distributing the impact points of the energy beam pulses on the moving surface appropriately, the light emission volume, which is the discharge volume, can be formed in the right way in order to optimally adapt the light emission volume to the acceptance area of an optical system, for example the optical system of a lithography scanner, thus allowing a more effective use of the generated radiation.

In addition to or instead of varying the lateral position of consecutive pulses within each discharge, the pulse groups of at least two different electrical discharges, preferably of consecutive electrical discharges - each pulse group being formed of the consecutive pulses of the corresponding electrical discharge - may be applied to the different lateral positions.

In an advantageous embodiment the energy beam pulses, either the consecutive pulses within each discharge or the pulse groups of different electrical discharges, are applied to the moving surface(s) such that a periodically repeating pattern of impact points is achieved on the moving surface(s). This pattern results as a combination of the movement of the corresponding surface, the time intervals between the pulses and the lateral distribution of the pulses. For example, the pattern may be selected to approximate a circular distribution of impact points or may be selected to comprise three impact points resulting from three pulses or pulse groups, each of these impact points forming a corner of an isosceles triangle.

The above proposed diagnostics and control unit may also be used to control the lateral positions of the pulses or pulse groups such that a desired geometry of the emission volume or of the EUV intensity within the collectable volume is achieved.

### BRIEF DESCRIPTION OF THE DRAWINGS

The proposed method and device are described in the following in connection with the accompanying drawings without limiting the scope of the claims. The figures show:
- Fig. 1: a schematic view of a device for generating EUV radiation or soft x-rays;
- Fig. 2: a schematic diagram showing the time delay between consecutive pulses applied within the time period of one electrical discharge;
- Fig. 3: a schematic image of the EUV radiation emitted by a plasma created by one single laser pulse according to the prior art;
- Fig. 4: a schematic image of the EUV emitted by a plasma created with two consecutive laser pulses according to the present invention; and
- Fig. 5: a schematic view of patterns of impact points on the moving surface according to one embodiment of the present invention.

### DETAILED DESCRIPTION OF EMBODIMENTS

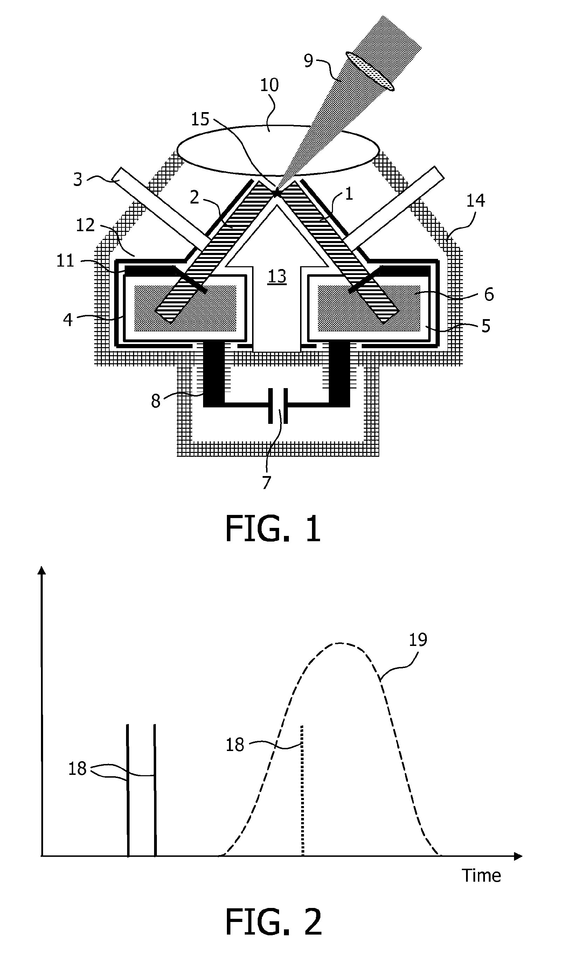

Figure 1 shows a schematic side view of a device for generating EUV radiation or soft x-rays to which the present method can be applied and which may be part of the device of the present invention. The device comprises two electrodes 1, 2 arranged in a vacuum chamber. The disc shaped electrodes 1, 2 are rotatably mounted, i.e. they are rotated during operation about rotational axis 3. During rotation the electrodes 1, 2 partially dip into corresponding containers 4, 5. Each of these containers 4, 5 contains a metal melt 6, in the present case liquid tin. The metal melt 6 is kept on a temperature of approximately 300°C, i.e. slightly above the melting point of 230°C of tin. The metal melt 6 in the containers 4, 5 is maintained at the above operation temperature by a heating device or a cooling device (not shown in the figure) connected to the containers. During rotation the surface of the electrodes 1, 2 is wetted by the liquid metal so that a liquid metal film forms on said electrodes. The layer thickness of the liquid metal on the electrodes 1, 2 can be controlled by means of strippers 11 typically in the range between 0.5 to 40 µm. The current to the electrodes 1, 2 is supplied via the metal melt 6, which is connected to the capacitor bank 7 via an insulated feed through 8.

With such a device, the surface of the electrodes is continuously regenerated so that no discharge wear of the base material of the electrodes occurs. The rotation of the electrode wheels through the metal melt results in a close heat contact between the electrodes and the metal melt such that the electrode wheels heated by the gas discharge can release their heat effectively to the melt. The low ohmic resistance between the electrode wheels and the metal melt furthermore allows conducting very high currents which are necessary to generate a sufficiently hot plasma for EUV radiation generation. A rotation of the capacitor bank delivering the current or elaborate current contacts is not required. The current can be delivered stationary via one or several feed throughs from outside of the metal melt.

The electrode wheels are advantageously arranged in a vacuum system with a basic vacuum of less than 10⁻⁴ hPa (10⁻⁴ mbar). A high voltage can be applied to the electrodes, for example a voltage of between 2 to 10 kV, without causing any uncontrolled electrical breakdown. This electrical breakdown is started in a controlled manner by an appropriate pulse of a pulsed energy beam, in the present example a laser pulse. The laser pulse 9 is focused on one of the electrodes 1, 2 at the narrowest point between the two electrodes, as shown in the figure. As a result, part of the metal film on the electrodes 1, 2 evaporates and bridges over the electrode gap. This leads to a disruptive discharge at this point accompanied by a very high current from the capacitor bank 7. The current heats the metal vapor, also called fuel in this context, to such high temperatures that the latter is ionized and emits the desired EUV radiation in pinch plasma 15.

In order to prevent the fuel from escaping from the device, a debris mitigation unit 10 is arranged in front of the device. This debris mitigation unit 10 allows the straight pass of radiation out of the device but retains a high amount of debris particles on their way out of the device. In order to avoid the contamination of the housing 14 of the device a screen 12 may be arranged between the electrodes 1, 2 and the housing 14. An additional metal screen 13 may be arranged between the electrodes 1, 2 allowing the condensed metal to flow back into the two containers 4, 5.

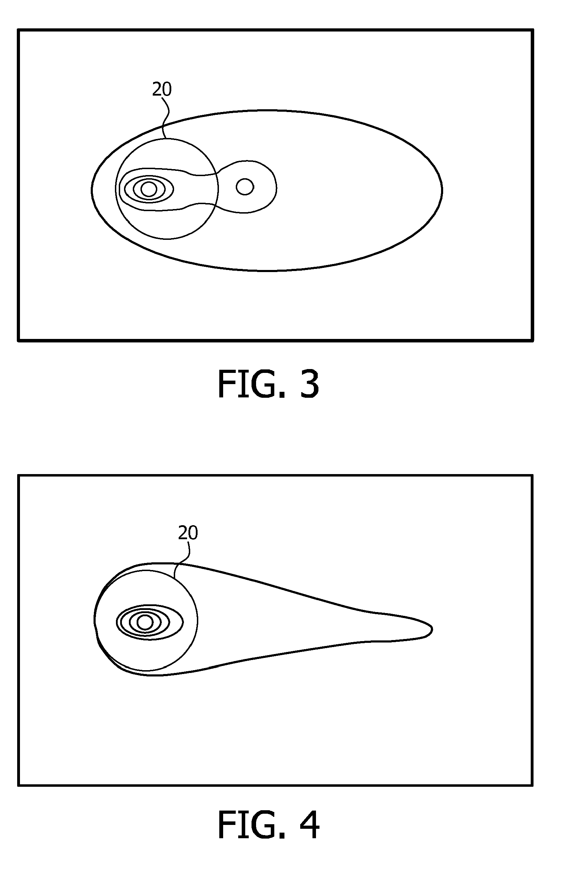

With such a EUV generating device, when used and constructed according to the prior art, one single laser pulse is used to initiate each electrical discharge. Figure 3 shows a schematic image of the EUV radiation emitted by a plasma created by one single laser pulse in such a device. To enhance the visibility of the low intensity emission region a logarithmic scale is taken. The different intensities are approximately indicated by the different shells drawn in this image. The outer shells show the lowest intensity wherein the innermost shell relates to the highest intensity. The closed circle denotes a typical collectable volume 20 for a EUV scanner. As can be seen from this image, outside of the collectable volume 20 also EUV radiation is emitted. In spite of the low intensity, the total amount of the energy emitted by the region outside of the collectable volume 20 is still significant due to its large volume. In the plasma depicted in figure 3, this means that only around half of the generated radiation can be used in a EUV scanner. The collectable conversion efficiency of this plasma equals 0.8%. This is close to the maximum that can be achieved when only one single laser pulse is used for the evaporation of tin in such a EUV generating device.

In order to increase the collectable conversion efficiency, in the present method and device more than one laser pulse per electrical discharge is used to generate the tin cloud. Figure 2 shows an embodiment, in which two consecutive laser pulses 18 with only 25 ns time difference are used to evaporate the tin. In this diagram, the duration of the electrical current pulse 19 is indicated with the dashed line and the two consecutive pulses 18 at the beginning of this current pulse 19 are shown. In this example, the second laser pulse is already applied before the formation of the electrical current pulse 19. The delay between the two consecutive laser pulses may also be increased such that the second laser pulse is applied during the electrical discharge (see dotted line in Fig. 2). The resulting spatial intensity distribution of the emitted EUV radiation is shown in figure 4 which can be directly compared with the image of figure 3. The total amount of EUV radiation generated is similar to that of figure 3, but the spatial distribution is much more concentrated in the collectable volume 20 denoted by the closed circle, which can be used by a EUV scanner. The collectable conversion efficiency of this plasma is around 1.3% which means an improvement in efficiency of more than 50% compared to the use of only one single laser pulse for each plasma discharge. It is obvious for the skilled person that the proposed method is not limited to the two consecutive laser pulses shown in Fig. 2. Also three or more consecutive laser pulses may be applied per electrical discharge in order to improve the collectable conversion efficiency.

The appropriate timing between the consecutive laser pulses may be achieved by using different lasers with each their own trigger which can be applied by appropriately modifying the device according to figure 1.

Instead of applying the consecutive pulses within each discharge or the groups of pulses of different discharges at the same lateral position with respect to the moving electrode surface, these pulses can also be applied at different lateral locations with respect to the moving direction of the surface of the rotating electrode wheel. With such a distribution of laser pulses or laser pulse impacts on the tin surface, a plasma pinch or radiation emitting volume is formed which has averaged over one or several discharges a higher extension in the direction of the diameter compared to the prior art. With such a larger diameter or extension in radial direction the relative spatial fluctuations are reduced. The device of figure 1 only has to be adapted to obtain such a distribution of laser pulses on the surface of the electrode wheel. This may be achieved using several laser light sources focusing at different lateral locations on the electrode wheel or by using a rotational or scanning optics between the laser light source and the surface of the electrode wheel.

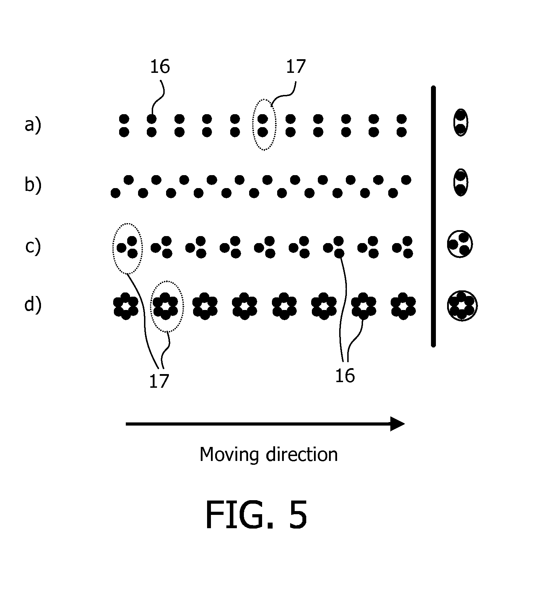

Figure 5 shows examples of impact patterns which can be achieved with such a lateral variation of the application of the laser pulses on the moving electrode surface. Depending on the time interval between the pulses or pulse groups a pattern 17 of impact points 16 as indicated in figures 5a and 5b is achieved on the surface. If the two laser pulses or laser pulse groups are applied in a very short time interval compared to the rotating speed of the electrode wheels, a pattern like in figure 5a is achieved. If all of the pulses are applied at the same time interval, a zigzag pattern as indicated in figure 5b is achieved.

Using three laser pulses or laser pulse groups for a pattern, a structure approximating an isosceles triangle may be achieved as indicated in figure 5c. Each of the impact points 16 is on the corner of the triangle. Such a pattern combines the advantage of the enhanced output power with the advantage of the larger emission region or volume of EUV radiation. This emission region is indicated with the closed circles on the right hand side in figures 5a to 5d. The three laser pulses or pulse groups to this end may be applied in very short distance in time compared to the rotation speed of the electrode wheels. The next discharge is then generated after a larger time interval as can be recognized from figure 5c.

While the invention has been illustrated and described in detail in the drawings and foregoing description, such illustration and description are to be considered illustrative or exemplary and not restrictive. The invention is not limited to the disclosed embodiments. The different embodiments described above and in the claims can also be combined. Other variations to the disclosed embodiments can be understood and effected by those skilled in the art in practicing the claimed invention, from the study of the drawings, the disclosure and the appended claims. For example, the application of consecutive pulses is not limited to the application of two consecutive pulses. It is also possible to use more than two lasers or consecutive pulses in order to achieve the desired increase of the collectable conversion efficiency. The invention is also not limited to EUV radiation or soft x-rays but may be applied to any kind of optical radiation which is emitted by an electrically operated discharge.

In the claims, the word "comprising" does not exclude other elements or steps, and the indefinite article "a" or "an" does not exclude a plurality. The mere fact that measures are recited in mutually different dependent claims does not indicate that a combination of these measures cannot be used to advantage. The reference signs in the claims should not be construed as limiting the scope of these claims.

### LIST OF REFERENCE SIGNS

- 1: electrode
- 2: electrode
- 3: rotational axis
- 4: container
- 5: container
- 6: metal melt
- 7: capacitor bank
- 8: feed through
- 9: laser pulse
- 10: debris mitigation unit
- 11: strippers
- 12: shield
- 13: metal screen
- 14: housing
- 15: pinch plasma
- 16: impact point
- 17: pattern
- 18: consecutive laser pulses
- 19: electrical current pulse
- 20: collectable volume

## Claims

1. A device for generating optical radiation, in particular EUV radiation or soft x-rays, by means of electrically operated discharges, comprising
- at least two electrodes (1, 2) arranged in a discharge space at a distance from one another which allows ignition of a plasma (15) in a gaseous medium between said electrodes (1, 2),
- a device for applying a liquid material (6) to one or several surface(s) moving through said discharge space,
- an energy beam device adapted to direct one or several pulsed energy beams onto said surface(s) evaporating said applied liquid material (6) at least partially thereby producing at least part of said gaseous medium,
- wherein said energy beam device is designed to apply within a time interval of each electrical discharge at least two consecutive pulses (9, 18) of said pulsed energy beam(s) onto said surface(s),
**characterised by**
- radiation sensors arranged for measuring a characteristic of said generated optical radiation and/or a dI/dt probe for determining an amount of fast ions generated by the discharge and
- a control unit connected to said energy beam device and controlling a time delay between the two consecutive pulses (9, 18) based on the measured characteristic and/or determined amount of fast ions.

2. The device according to claim 1,
wherein said energy beam device is designed to apply said at least two consecutive pulses (9, 18) with a mutual time delay of ≤ 300 ns.

3. The device according to claim 1,
wherein said energy beam device is designed to apply said at least two consecutive pulses (9, 18) of each electrical discharge and/or pulse groups of at least two different electrical discharges at different lateral locations with respect to a moving direction of said surface(s).

4. The device according to claim 3,
wherein said energy beam device is designed to apply the pulses or pulse groups of said pulsed energy beam(s) to achieve a periodically repeating pattern (17) of impact points (16) at said surface(s) during operation of the device.

5. The device according to claim 1,
wherein said device for applying a liquid material (6) is adapted to apply the liquid material (6) to a surface of at least one of said electrodes (1, 2), said at least one of said electrodes (1, 2) being designed as a rotatable wheel which can be placed in rotation during operation.

6. The device according to claim 1,
wherein the control unit is designed to control the time delay between the two consecutive pulses (9, 18) to achieve a maximum EUV output and/or a minimum amount of fast ions generated by the discharge.

7. A method of generating optical radiation, in particular EUV radiation or soft x-rays, by means of electrically operated discharges, in which
- a plasma (15) is ignited in a gaseous medium between at least two electrodes (1, 2) in a discharge space, said plasma (15) emitting said radiation that is to be generated,
- wherein said gaseous medium is produced at least partly from a liquid material (6), which is applied to one or several surface(s) moving in said discharge space and is at least partially evaporated by one or several pulsed energy beam(s),
**characterised in that**
- at least two consecutive pulses (9, 18) of said pulsed energy beam(s) are applied within a time interval of each electrical discharge onto said surface(s), and
- a characteristic of said generated optical radiation and/or an amount of fast ions generated by the discharge is detected and a time delay between the two consecutive pulses (9, 18) is controlled based on measurement data of said detection.

8. The method according to claim 7,
wherein said at least two consecutive pulses (9, 18) are applied with a mutual time delay of ≤ 300 ns.

9. The method according to claim 7,
wherein said at least two consecutive pulses (9, 18) of each electrical discharge and/or pulse groups of at least two different electrical discharges are applied at different lateral locations with respect to a moving direction of said surface(s).

10. The method according to claim 9,
wherein the pulses or pulse groups of said pulsed energy beam(s) are applied to the surface(s) such that a periodically repeating pattern (17) of impact points (16) is achieved at said surface(s) during movement of said surface(s).

11. The method according to claim 7,
wherein the time delay between the two consecutive pulses (9, 18) is controlled to achieve maximum EUV output and/or minimum amount of fast ions.

12. A method according to claim 7,
wherein at least one of said electrodes (1, 2) is set in rotation during operation, said liquid material (6) being applied to a surface of said at least one of said electrodes (1, 2).

## Patentansprüche

1. Vorrichtung zum Erzeugen von optischer Strahlung, insbesondere von EUV-Strahlung oder weichen Röntgenstrahlen, mittels elektrisch betätigter Entladungen, wobei die Vorrichtung Folgendes umfasst:
- mindestens zwei Elektroden (1, 2), die in einem Entladungsraum in einem Abstand voneinander angeordnet sind, der die Zündung eines Plasmas (15) in einem gasförmigen Medium zwischen den genannten Elektroden (1, 2) erlaubt,
- eine Vorrichtung zum Auftragen eines flüssigen Materials (6) auf eine oder mehrere Oberfläche(n), die sich durch den genannten Entladungsraum bewegen,
- eine Energiestrahlvorrichtung, die dafür ausgelegt ist, ein oder mehrere gepulste Energiestrahlenbündel auf die genannte(n) Oberfläche(n) zu richten, um das genannte aufgetragene flüssige Material (6) zumindest teilweise zu verdampfen und dadurch mindestens einen Teil des genannten gasförmigen Mediums zu erzeugen,
- wobei die genannte Energiestrahlvorrichtung dafür eingerichtet ist, innerhalb eines Zeitintervalls jeder elektrischen Entladung mindestens zwei aufeinanderfolgende Impulse (9, 18) des (der) genannten gepulsten Energiestrahlenbündel(s) an die genannte(n) Oberfläche(n) anzulegen,
**gekennzeichnet durch**
- Strahlungssensoren, die dafür ausgelegt sind, eine Eigenschaft der genannten erzeugten optischen Strahlung zu messen, und/oder eine dI/dt-Sonde zum Ermitteln einer Menge an schnellen Ionen, die **durch** die Entladung erzeugt wurden und
- eine Steuereinheit, die mit der genannten Energiestrahlvorrichtung verbunden ist und eine Zeitverzögerung zwischen den beiden aufeinanderfolgenden Impulsen (9, 18) basierend auf der gemessenen Eigenschaft und/oder der ermittelten Menge an schnellen Ionen steuert.

2. Vorrichtung nach Anspruch 1,
wobei die genannte Energiestrahlvorrichtung dafür eingerichtet ist, die genannten mindestens zwei aufeinanderfolgenden Impulse (9, 18) mit einer wechselseitigen Zeitverzögerung von ≤ 300 ns anzulegen.

3. Vorrichtung nach Anspruch 1,
wobei die genannte Energiestrahlvorrichtung dafür eingerichtet ist, die genannten mindestens zwei aufeinanderfolgenden Impulse (9, 18) jeder elektrischen Entladung und/oder Impulsgruppen von mindestens zwei unterschiedlichen elektrischen Entladungen an verschiedenen seitlichen Orten in Bezug auf eine Bewegungsrichtung der genannten Oberfläche(n) anzulegen.

4. Vorrichtung nach Anspruch 3,
wobei die genannte Energiestrahlvorrichtung dafür eingerichtet ist, die Impulse oder Impulsgruppen des (der) genannten gepulsten Energiestrahlenbündel anzulegen, um während des Betriebs der Vorrichtung ein sich periodisch wiederholendes Muster (17) von Aufprallpunkten (16) an der (den) genannten Oberfläche(n) zu erreichen.

5. Vorrichtung nach Anspruch 1,
wobei die genannte Vorrichtung zum Auftragen eines flüssigen Materials (6) dafür ausgelegt ist, das flüssige Material (6) auf eine Oberfläche von mindestens einer der genannten Elektroden (1, 2) aufzutragen, wobei die genannte mindestens eine der genannten Elektroden (1, 2) als ein drehbares Rad konzipiert ist, das während des Betriebs in Drehung versetzt werden kann.

6. Vorrichtung nach Anspruch 1,
wobei die Steuereinheit dafür eingerichtet ist, die Zeitverzögerung zwischen den beiden aufeinanderfolgenden Impulsen (9, 18) zu steuern, um eine maximale EUV-Abstrahlung und/oder eine minimale Menge an schnellen Ionen zu erreichen, die durch die Entladung erzeugt werden.

7. Verfahren des Erzeugens von optischer Strahlung, insbesondere von EUV-Strahlung oder weichen Röntgenstrahlen, mittels elektrisch betätigter Entladungen, wobei:
- ein Plasma (15) in einem gasförmigen Medium zwischen mindestens zwei Elektroden (1, 2) in einem Entladungsraum gezündet wird, wobei das genannte Plasma (15) die genannte zu erzeugende Strahlung emittiert,
- wobei das genannte gasförmige Medium zumindest teilweise aus einem flüssigen Material (6) erzeugt wird, das auf eine oder mehrere Oberfläche(n), die sich in dem genannten Entladungsraum bewegt (bewegen), aufgetragen wird und das zumindest teilweise durch ein oder mehrere gepulste Energiestrahlenbündel verdampft wird,
**dadurch gekennzeichnet, dass**
- mindestens zwei aufeinanderfolgende Impulse (9, 18) des (der) genannten gepulsten Energiestrahlenbündel(s) innerhalb eines Zeitintervalls jeder elektrischen Entladung an die genannte(n) Oberfläche(n) angelegt wird, und
- eine Eigenschaft der genannten erzeugten optischen Strahlung und/oder eine Menge an schnellen Ionen, die durch die Entladung erzeugt werden, detektiert wird und eine Zeitverzögerung zwischen den beiden aufeinanderfolgenden Impulsen (9, 18) basierend auf den Messdaten der genannten Detektion gesteuert wird.

8. Verfahren nach Anspruch 7,
wobei die genannten mindestens zwei aufeinanderfolgenden Impulse (9, 18) mit einer wechselseitigen Zeitverzögerung von ≤ 300 ns angelegt werden.

9. Verfahren nach Anspruch 7,
wobei die genannten mindestens zwei aufeinanderfolgenden Impulse (9, 18) jeder elektrischen Entladung und/oder Impulsgruppen von mindestens zwei unterschiedlichen elektrischen Entladungen an verschiedenen seitlichen Orten in Bezug auf eine Bewegungsrichtung der genannten Oberfläche(n) angelegt werden.

10. Verfahren nach Anspruch 9,
wobei die Impulse oder Impulsgruppen des (der) genannten gepulsten Energiestrahlenbündel derartig an die Oberfläche(n) angelegt werden, dass während der Bewegung der genannten Oberfläche(n) ein sich periodisch wiederholendes Muster (17) von Aufprallpunkten (16) an der (den) genannten Oberfläche(n) erreicht wird.

11. Verfahren nach Anspruch 7,
wobei die Zeitverzögerung zwischen den beiden aufeinanderfolgenden Impulsen (9, 18) gesteuert wird, um eine maximale EUV-Abstrahlung und/oder eine minimale Menge an schnellen Ionen zu erreichen.

12. Verfahren nach Anspruch 7,
wobei mindestens eine der genannten Elektroden (1, 2) während des Betriebs in Drehung versetzt wird, wobei das genannte flüssige Material (6) auf eine Oberfläche der genannten mindestens einen der genannten Elektroden (1, 2) aufgetragen wird.

## Revendications

1. Dispositif pour générer un rayonnement optique, en particulier un rayonnement EUV ou des rayons X mous, au moyen de décharges commandées électriquement, comprenant :
- au moins deux électrodes (1, 2) agencées dans un espace de décharge, à une distance l'une de l'autre, qui permet l'allumage d'un plasma (15) dans un milieu gazeux entre lesdites électrodes (1, 2),
- un dispositif pour appliquer un matériau liquide (6) sur une ou plusieurs surface(s) se déplaçant à travers ledit espace de décharge,
- un dispositif à faisceau énergétique adapté pour diriger un ou plusieurs faisceaux énergétiques à impulsions sur ladite/lesdites surface(s), évaporant ledit matériau liquide appliqué (6) au moins partiellement, produisant ainsi au moins une partie dudit milieu gazeux,
- dans lequel ledit dispositif à faisceau énergétique est conçu pour appliquer, au sein d'un intervalle de temps de chaque décharge électrique, au moins deux impulsions consécutives (9, 18) dudit/desdits faisceau(x) énergétique(s) à impulsions sur ladite/lesdites surface(s),
**caractérisé par**
- des capteurs de rayonnement agencés pour mesurer une caractéristique dudit rayonnement optique généré et/ou une sonde dI/dt pour déterminer une quantité d'ions rapides générés par la décharge, et
- une unité de commande connectée audit dispositif à faisceau énergétique et commandant un retard entre les deux impulsions consécutives (9, 18) en fonction de la caractéristique mesurée et/ou de la quantité déterminée d'ions rapides.

2. Dispositif selon la revendication 1,
dans lequel ledit dispositif à faisceau énergétique est conçu pour appliquer lesdites au moins deux impulsions consécutives (9, 18) avec un retard mutuel de ≤ 300 ns.

3. Dispositif selon la revendication 1,
dans lequel ledit dispositif à faisceau énergétique est conçu pour appliquer lesdites au moins deux impulsions consécutives (9, 18) de chaque décharge électrique et/ou lesdits groupes d'impulsions d'au moins deux décharges électriques différentes à des localisations latérales différentes par rapport à une direction de déplacement de ladite/desdites surface(s).

4. Dispositif selon la revendication 3,
dans lequel ledit dispositif à faisceau énergétique est conçu pour appliquer les impulsions ou groupes d'impulsions dudit/desdits faisceau(x) énergétique(s) à impulsions pour obtenir un motif se répétant périodiquement (17) de points d'impact (16) au niveau de ladite/desdites surface(s) durant le fonctionnement du dispositif

5. Dispositif selon la revendication 1,
dans lequel ledit dispositif pour appliquer un matériau liquide (6) est adapté pour appliquer le matériau liquide (6) sur une surface d'au moins une desdites électrodes (1, 2), ladite au moins une desdites électrodes (1, 2) étant conçue sous forme de roue rotative qui peut être mise en rotation durant le fonctionnement.

6. Dispositif selon la revendication 1,
dans lequel l'unité de commande est conçue pour commander le retard entre les deux impulsions consécutives (9, 18) pour obtenir un rendement EUV maximum et/ou une quantité minimum d'ions rapides générés par la décharge.

7. Procédé de génération de rayonnement optique, en particulier d'un rayonnement EUV ou de rayons X mous, au moyen de décharges commandées électriquement, dans lequel
- un plasma (15) est allumé dans un milieu gazeux entre au moins deux électrodes (1, 2) dans un espace de décharge, ledit plasma (15) émettant ladite radiation qui doit être générée,
- dans lequel ledit milieu gazeux est produit au moins partiellement à partir d'un matériau liquide (6), qui est appliqué sur une ou plusieurs surface(s) se déplaçant dans ledit espace de décharge et est au moins partiellement évaporé par un ou plusieurs faisceau(x) énergétique(s) à impulsions,
**caractérisé en ce que**
- au moins deux impulsions consécutives (9, 18) dudit/desdits faisceau(x) énergétique(s) à impulsions sont appliquées au sein d'un intervalle de temps de chaque décharge électrique sur ladite/lesdites surface(s), et
- une caractéristique dudit rayonnement optique généré et/ou une quantité d'ions rapides générés par la décharge est détectée et un retard entre les deux impulsions consécutives (9, 18) est contrôlé en fonction de données de mesure de ladite détection.

8. Procédé selon la revendication 7,
dans lequel lesdites au moins deux impulsions consécutives (9, 18) sont appliquées avec un retard mutuel de ≤ 300 ns.

9. Procédé selon la revendication 7,
dans lequel lesdites au moins deux impulsions consécutives (9, 18) de chaque décharge électrique et/ou lesdits groupes d'impulsions d'au moins deux décharges électriques différentes sont appliqués à des localisations latérales différentes par rapport à une direction de déplacement de ladite/desdites surface(s).

10. Procédé selon la revendication 9,
dans lequel les impulsions ou groupes d'impulsions dudit/lesdits faisceau(x) énergétique(s) à impulsions sont appliqués sur la/les surface(s) de sorte qu'un motif se répétant périodiquement (17) de points d'impact (16) soit obtenu au niveau de ladite/desdites surface(s) durant le mouvement de ladite/desdites surface(s).

11. Procédé selon la revendication 7,
dans lequel le retard entre les deux impulsions consécutives (9, 18) est contrôlé pour obtenir un rendement EUV maximum et/ou une quantité minimum d'ions rapides.

12. Procédé selon la revendication 7,
dans lequel au moins une desdites électrodes (1, 2) est mise en rotation durant le fonctionnement, ledit matériau liquide (6) étant appliqué sur une surface de ladite au moins une desdites électrodes (1, 2).
